Europäisches Patentamt

European Patent Office

Office européen des brevets

(19)

(11) Numéro de publication: **0 230 840 B1**

(12) **FASCICULE DE BREVET EUROPEEN**

(45) Date de publication de fascicule du brevet:
25.09.91

(51) Int. Cl.5: **H01L 29/10, H01L 29/72, H01L 21/28**

(21) Numéro de dépôt: **86420263.5**

(22) Date de dépôt: **27.10.86**

(54) **Transistor à base perméable et procédés de fabrication.**

(30) Priorité: **29.10.85 FR 8516329**

(43) Date de publication de la demande:
**05.08.87 Bulletin 87/32**

(45) Mention de la délivrance du brevet:
**25.09.91 Bulletin 91/39**

(84) Etats contractants désignés:
**DE FR GB IT NL**

(56) Documents cités:

**IEEE ELECTRON DEVICE LETTERS, vol. EDL-6, no. 6, juin 1985, pages 264-266, IEEE, New York, US; S. ADACHI et al.: "A new gate structure vertical-GaAs FET"**

**JAPANESE JOURNAL OF APPLIED PHYSICS. SUPPLEMENTS 16TH INT. CONF. SOLID STATE DEVICES AND MATERIALS, Kobe, 30 août - 1er septembre 1984, pages 305-308, Tokyo, JP; D.D. RATHMAN et al.: "Silicon permeable base transistors"**

(73) Titulaire: **ETAT FRANCAIS représenté par le Secrétaire d'Etat aux Postes et Télécommunications et à la Télédiffusion (CENTRE NATIONAL D'ETUDES DES TELECOMMUNICATIONS) 38-40 rue du Général Leclerc F-92131 Issy-les-Moulineaux(FR)**

(72) Inventeur: **Rosencher, Emmanuel Belmont F-38410 Uriage(FR)**
Inventeur: **Delage, Sylvain 82, Rue de Verdun A2 F-94500 Champigny sur Marne(FR)**
Inventeur: **Vincent, Gilbert 22 Chemin de la Revirée F-38240 Meylan(FR)**

(74) Mandataire: **de Beaumont, Michel 1bis, rue Champollion F-38000 Grenoble(FR)**

JAPANESE JOURNAL OF APPLIED PHYSICS. SUPPLEMENTS 16TH INT. CONF. SOLID STATE DEVICES AND MATERIALS, Kobe, 30 août - 1er septembre 1984, pages 39-42, Tokyo, JP; A. ISHIZAKA et al.: "Overgrowth and characterization of epitaxial silicon on patterned NiSi2 grown by molecular beam epitaxy"

## Description

La présente invention concerne le domaine des composants semiconducteurs discrets ou intégrés et plus particulièrement les transistors sur silicium dits à base perméable qui sont des transistors à haute rapidité et qui permettent de traiter des puissances relativement importantes.

De façon générale, les transistors à base perméable sont des transistors de type vertical qui comprennent, sur un substrat semiconducteur, une grille et une deuxième couche, ou couche supérieure, semiconductrice. Les deux faces du dispositif sont recouvertes de métallisations et une connexion est prévue sur la grille. Ces transistors peuvent être normalement passants ou normalment bloqués selon que les deux couches de silicium (le substrat et la couche supérieure) ont une largeur de zone désertée plus petite ou plus grande, respectivement, que la largeur d'espacement de grille. La conduction ou la non-conduction du transistor est assurée par l'effet de pincement des lignes de champ produit par la polarisation appliquée sur la grille.

Un inconvénient notable de ce type de transistor est que, à l'ouverture, il faut appliquer des puissances importantes sur la grille pour interrompre le courant circulant dans le transistor, notamment à cause des courants de fuite des jonctions métal-semiconducteur.

Pour résoudre cet inconvénient et d'autres, S. Adachi et al. ont proposé dans un article paru dans IEEE Electron Devices Letters, vol. EDL - 6, N° 6, juin 1985, une structure de transistor à grille perméable au GaAs dans laquelle la grille est constituée d'un sandwich isolant/métal/isolent enterré dans un monocristal de GaAs. L'isolant est du $SiO_2$ et le conducteur de grille est du tungstène. Les domaines des transistors GaAs et des transistors au silicium sont des domaines nettement distincts. Les technologies utilisées dans ces deux domaines sont différentes et l'homme de l'art de l'un de ces domaines n'est pas compétent dans l'autre. Une transposition directe d'une technique utilisée pour l'AsGa vers le silicium n'est pas possible.

Un objet de la présente invention est de prévoir une structure de transistor au silicium à base perméable à grille isolée et un procédé de fabrication de cette structure permettant de fournir un résultat techniquement satisfaisant.

En effet, si, pour obtenir une structure telle que décrite par Adachi, on forme sur du silicium une couche d'oxyde déposée électrolytiquement, une couche de tungstène puis une couche d'oxyde déposée électrolytiquement, on aura les inconvénients suivants :

- le sandwich d' ensemble sera extrêmement épais,
- lors de l'étape d'épitaxie destinée à former la couche supérieure de silicium enterrant la grille, ou lors d'étapes thermiques ultérieures, le tungstène diffusera dans le silicium et les propriétés recherchées ne pourront plus être obtenues,
- on ne pourra obtenir une croissance épitaxiale monocristalline régulière sans défaut ni lacune à l'interface avec le tungstène et l'oxyde de silicium, ce qui entraîne un non fonctionnement du dispositif en raison de la création de charges fixes dans les zones polycristallines perturbées.

Ainsi, la présente invention prévoit un transistor à base perméable comprenant, enterrée dans un monocristal de silicium, une grille formée d'un sandwich isolant/conducteur/isolant, ledit sandwich étant constitué d'un siliciure métallique réfractaire isolé sur ses deux faces inférieure et supérieure par une couche d'oxyde de silicium thermique.

La présente invention vise également des procédés de fabrication de ces transistors qui seront exposés plus en détail ci-après.

Les objets, caractéristiques et avantages de la présente invention apparaîtront plus clairement à la lecture de la description suivante faite en relation avec les figures jointes parmi lesquelles :

les figures 1A, 1B, 1C et 1D sont des vues en coupe représentant des étapes successives de fabrication d'un transistor à base perméable selon un premier mode de réalisation de la présente invention ;

les figures 2A, 2B, 2C et 2D sont des vues en coupe représentant des étapes successives de fabrication d'un transistor à base perméable selon un second mode de fabrication de la présente invention.

Comme cela est usuel dans le domaine de la représentation des semiconducteurs, on notera que les épaisseurs et les dimensions latérales des diverses couches dans les figures ne sont pas tracées à l'échelle mais sont arbitrairement agrandies les unes par rapport aux autres pour faciliter la lisibilité des figures. De même, les figures représentent des parties de dispositifs qui seront généralement fabriqués par lots sur des tranches de grande dimension contenant une multitude de structures identiques répétées ou bien encore divers dispositifs dont certains du type décrit pour constituer des circuits intégrés.

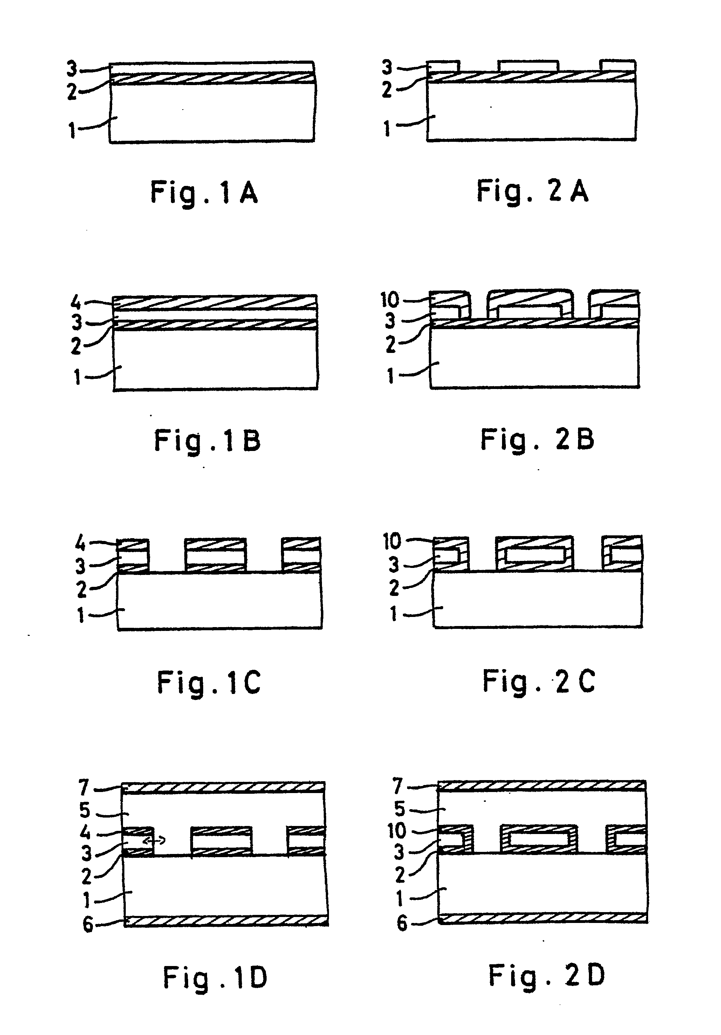

Un premier mode de réalisation d'un transistor à base perméable selon la présente invention va être décrit en relation avec son procédé de fabrication illustré aux figures 1A à 1D.

La figure 1A représente une étape initiale de fabrication dans laquelle on forme sur un substrat semiconducteur 1 de silicium une couche 2 d'oxyde de silicium ($SiO_2$) puis une couche 3 d'un siliciure métallique réfractaire, par exemple du WSi$_2$. La couche 2 de SiO$_2$ est formée par oxydation thermique et peut avoir une épaisseur de l'ordre de 10 à 100 nm. La couche 3 de WSi$_2$ est par exemple formée par pulvérisation cathodique et peut avoir une épaisseur de l'ordre de 100 à 200 nm.

Ensuite, corne le représente la figure 1B, on forme sur la couche 3 de WSi$_2$ une deuxième couche d'oxyde de silicium 4, par oxydation thermique selon une épaisseur de 10 à 100 nm. Pour faciliter la formation de cette deuxième couche, le siliciure de tungstène est de préférence sur-stoechiométrique, par exemple WSi$_{2,3}$.

Après quoi, comme le représente la figure 1C, des fenêtres sont ouvertes dans l'ensemble des couches 2, 3 et 4 pour fournir une configuration de grille souhaitée, par exemple une configuration en bandes parallèles, l'intervalle entre bandes pouvant être de l'ordre du micromètre et la largeur des bandes de l'ordre de 2 micromètres. Le dispositif est ensuite achevé, comme le représente la figure 1D en formant au-dessus de la grille et dans les ouvertures de cette grille une couche de silicium 5 par croissance épitaxiale. Ensuite, des couches de métallisation 6 et 7 sont formées sur les deux faces du dispositif. Bien entendu, les divers procédés classiques de fabrication de semiconducteurs sont utilisés pour établir des contacts avec la grille de WSi$_2$ à partir de la face supérieure, pour assurer un contact ohmique entre les métallisations et les couches de silicium avec lesquelles elles sont en contact, etc..

Cette structure particulière du sandwich de grille présente notamment les avantages suivants :

- le fait de choisir pour les couches isolantes inférieure et supérieure des couches d'oxyde de silicium thermique, permet d'obtenir des couches de très bonne qualité et de très faible épaisseur comme l'indiquent les ordres de grandeur ci-dessus. Il en résulte que l'ensemble du sandwich pourra présenter une épaisseur totale très faible, petite devant la dimension des ouvertures de la grille. Notamment, on obtiendra une épaisseur de sandwich de grille inférieure au tiers de la dimension des ouvertures de grille. Ceci favorisera le recouvrement épitaxial monocristallin de la surface supérieure de la grille. Ce recouvrement est également favorisé du fait que la couche isolante supérieure est une couche de silice thermique, une telle couche présentant une bonne régularité et une bonne compatibilité épitaxiale avec le silicium.

- le fait de choisir pour le conducteur de grille un siliciure métallique réfractaire tel que WSi$_2$ entraîne au moins trois avantages. Le premier est que le silicium réfractaire ne diffusera pas dans le silicium lors de l'épitaxie qui peut être effectuée à des températures s'élevant jusqu'à 1000°C. Le deuxième est que cela permet de former l'oxyde thermique susmentionné au dessus de la couche conductrice. Le troisième est qu'un siliciure métallique tel que WSi$_2$ ou CoSi$_2$ présente un très bon accord épitaxique avec le silicium. L'accord étant pratiquement parfait pour WSi$_2$ et le désaccord n'étant pas supérieur à 10 % pour CoSi$_2$.

On notera incidemment que ces problèmes ne se posent pas ou se posent de façon totalement différente dans le cas d'une structure à base d'arséniure de gallium.

On obtient ainsi un transistor à base perméable avec un contact de type Schottky entre la base et les zones de silicium disposées dans les ouvertures de la grille.

Dans un deuxième mode de réalisation d'un transistor à base perméable selon la présente invention, la grille est complétement isolée du silicium.

Les figures 2A à 2D illustrent à titre d'exemple un procédé de fabrication d'un transistor à base perméable selon ce deuxième mode de réalisation de l'invention.

Pour réaliser cette structure, on part d'un corps semiconducteur tel que représenté en figure 1A, sauf que la couche d'oxyde de silicium 2 est remplacée par une couche isolante comprenant, par exemple, une couche mince d'oxyde de silicium thermique (épaisseur de l'ordre du nanomètre) suivie d'une couche de nitrure de silicium. Ensuite, comme le représente la figure 2A, des fenêtres sont ouvertes dans la couche 3 de WSi$_2$ selon la configuration de grille souhaitée. Puis, une oxydation thermique est effectuée pour développer une couche d'oxyde de silicium 10 sur les faces supérieure et latérales de la grille 3 de WSi$_2$. On notera, qu'en raison de la présence du nitrure de silicium, cette oxydation thermique ne se développera pas dans les fenêtres de la grille sur le substrat 1. Une fois obtenue une couche 10 d'oxyde plus épaisse que la partie d'oxyde de silicium de la couche 2, on procède à une attaque sélective du nitrure de silicium suivie d'une attaque de l'oxyde de silicium pour enlever complètement la couche isolante au-dessus du substrat 1 dans les ouvertures de la grille tout en laissant en place une partie de la couche d'oxyde de silicium 10 sur les faces supérieure et latérale de la grille de WSi$_2$. On obtient ainsi une grille complétement isolée représentée en figure 2C. Après quoi, on procède aux mêmes étapes que celles décrites précédemment en relation avec 1a figure 1D pour arriver à la structure de la figure 2D.

Bien entendu, la présente invention est susceptible de nombreuses variantes qui apparaîtront à l'homme de l'art qui pourra combiner la structure décrite ci-dessus, ainsi que les étapes de procédés selon la présente invention, à diverses structures et étapes classiques pour modifier cette structure dans des buts particuliers.

## Revendications

1. Transistor à base perméable comprenant, enterrée dans un monocristal de silicium, une grille formée d'un sandwich isolant/conducteur/isolant, ledit sandwich étant constitué d'un siliciure métallique réfractaire (3) isolé sur ses deux faces inférieure et supérieure par une couche d'oxyde de silicium thermique (2, 4).

2. Transistor selon la revendication 1, caractérisé en ce que le siliciure est choisi dans le groupe comprenant le siliciure de tungstène (WSi$_2$), et le siliciure de cobalt (CoSi$_2$).

3. Transistor selon l'une des revendications 1 ou 2, caractérisé en ce que les faces latérales de la grille sont également isolées.

4. Procédé de fabrication d'un transistor à base perméable selon la revendication 1 à partir d'un substrat de silicium monocristallin, comprenant les étapes successives suivantes :
   - oxyder thermiquement la surface du substrat de silicium (1), pour former une première couche d'oxyde de silicium (2),
   - former sur la couche d'oxyde (2) une couche d'un siliciure métallique réfractaire (3),
   - oxyder thermiquement la surface supérieure de la couche de siliciure (3), pour former une seconde couche d'oxyde de silicium (4),
   - ouvrir des fenêtres selon la configuration de grille souhaitée dans l'ensemble de la première couche d'oxyde de silicium, de la couche de siliciure et de la deuxième couche d'oxyde de silicium,
   - former par épitaxie une deuxième couche de silicium monocristallin (5) au-dessus de la grille et dans les fenêtres ouvertes.

5. Procédé de fabrication d'un transistor à base perméable selon la revendication 3 à partir d'un substrat de silicium, comprenant les étapes successives suivantes :
   - oxyder thermiquement la surface du substrat de silicium,
   - former et ouvrir selon une configuration de grille souhaitée une couche d'un siliciure métallique (3),
   - oxyder thermiquement le siliciure métallique pour former une seconde couche isolante d'oxyde de silicium (10) sur la surface et les faces latérales de la couche de siliciure,
   - attaquer la première couche d'oxyde thermique dans les ouvertures en laissant en place au moins en partie la seconde couche d'oxyde thermique,
   - former par épitaxie au-dessus de la grille et dans les ouvertures une deuxième couche de silicium (5).

## Claims

1. A permeable base transistor comprising, embedded in single-crystal silicon, a gate formed by an insulator/conductor/insulator sandwich, said sandwich being constituted by a high-melting metal silicide (3) isolated on its lower and upper surfaces by a thermal silicon oxide layer (2, 4).

2. A transistor according to claim 1, characterized in this that said silicide is selected among the group comprising tungsten silicide (WSi$_2$) and cobalt silicide (CoSi$_2$).

3. A transistor according to claim 1 or 2, characterized in this that the lateral surfaces of the gate are also isolated.

4. A process for manufacturing a permeable base transistor according to claim 1, from a single-crystal silicon substrate, comprising the successive following steps:
   - thermally oxidizing the surface of said silicon substrate (1) to form a first silicon oxide layer (2),
   - forming on said oxide layer (2) a high-melting metal silicide layer (3),
   - thermally oxidizing the upper surface of said silicon layer (3), for forming a second silicon oxide layer (4),
   - opening windows according to the desired gate configuration in the first silicon oxide layer, the silicide layer and the second silicon oxide layer,
   - epitaxially growing a second single-crystal silicon layer (5) above said gate and in said windows.

5. A process for manufacturing a permeable base transistor according to claim 3, from a silicon substrate, comprising the following successive steps:

- thermally oxidizing the surface of said silicon substrate,
- forming and etching a metal silicide layer (3) according to a desired gate configuration,
- thermally oxidizing said metal silicide for forming a second isolating silicon oxide layer (10) on the surface and lateral edges of said silicide layer,
- etching said first thermal oxide layer in the apertures, while leaving in place at least portions of said second thermal oxide layer,
- epitaxially growing a second silicon layer (5) above said gate and in said apertures.

**Patentansprüche**

1. Transistor mit permeabler Basis mit einem in monokristallinem Silizium eingebetteten Gitter, das als Schichtenfolge Isolierung/Leiter/Isolierung ausgebildet ist, wobei diese Schichtenfolge aus einem hoch schmelzbaren Metall-Silizid (3) besteht, das auf seiner Ober- und Unterfläche durch ein thermisches Siliziumoxid abgedeckt ist.

2. Transistor nach Anspruch 1, dadurch gekennzeichnet, daß das Silizid aus der Gruppe ausgewählt ist, die Wolframsilizid ($WSi_2$) und Kobaltsilizid ($CoSi_2$) enthält.

3. Transistor nach einem der Ansprüche 1 und 2, dadurch gekennzeichnet, daß die Seitenflächen des Gitters ebenfalls abgedeckt sind.

4. Verfahren zur Herstellung eines Transistors mit permeabler Basis gemäß dem Patentanspruch 1, ausgehend von einem Substrat aus monokristallinem Silizium, welches die folgenden Schritte aufweist:
   - thermisches Oxidieren der Oberfläche des Siliziumsubstrats (1), um eine erste Schicht aus Siliziumoxid (2) zu bilden,
   - Ausbilden einer Schicht aus schwer schmelzbarem Metall-Silizid (3) auf der Oxidschicht (2),
   - thermisches Oxidieren der Oberfläche der Silizidschicht (3), um eine zweite Schicht aus Siliziumoxid (4) zu bilden,
   - Öffnen von Fenstern entsprechend der gewünschten Konfiguration des Gitters in der Anordnung der ersten Siliziumoxidschicht, der Silizidschicht und der zweiten Siliziumoxidschicht,
   - epitaktisches Bilden einer zweiten monokristallinen Siliziumschicht (5) auf dem Gitter und in den offenen Fenstern.

5. Verfahren zur Herstellung eines Transistors mit permeabler Basis gemäß Patentanspruch 3, ausgehend von einem Siliziumsubstrat, welches folgende Schritte aufweist:
   - thermisches Oxidieren der Oberfläche des Siliziumsubstrats,
   - Bilden und Öffnen einer Metall-Silizidschicht (3) entsprechend einer gewünschten Konfiguration des Gitters,
   - thermisches Oxidieren des Metall-Silizids, um eine zweite isolierende Schicht (10) aus Siliziumoxid auf der Oberfläche und den Seitenflächen der Siliziumschicht zu bilden,
   - Abtragen der ersten thermischen Oxidschicht in den Öffnungen, wobei zumindest teilweise die zweite thermische Oxidschicht belassen wird,
   - epitaktisches Bilden einer zweiten Siliziumschicht (5) auf dem Gitter und in den Öffnungen.

Fig. 1 A

Fig. 2 A

Fig. 1 B

Fig. 2 B

Fig. 1C

Fig. 2 C

Fig. 1D

Fig. 2 D